# EUROPEAN PATENT APPLICATION

(11) **EP 3 040 981 A1**
(43) Date of publication of application: **06.07.2016**
(21) Application number: 15763474.2
(22) Date of filing: 23.03.2015
(51) Int. Cl.: G09G 3/36, G11C 19/28

(54) **SHIFT REGISTER UNIT CIRCUIT, SHIFT REGISTER, DRIVING METHOD AND DISPLAY DEVICE**

(30) Priority: 31.10.2014 CN 201410602816
(71) Applicant: BOE Technology Group Co., Ltd., Chaoyang District, Beijing 100016 (CN); BEIJING BOE DISPLAY TECHNOLOGY CO., LTD., Beijing 100176 (CN)
(72) Inventor: WANG, Zheng, Beijing 100176 (CN)
(74) Representative: Mattsson, Niklas
(86) International application number: PCT/CN2015/074852
(87) International publication number: WO 2016/065817

(57) **Abstract**

The present disclosure relates to the field of display technology, and discloses a shift register unit circuit, comprising a trigger signal end, a first clock end, a second clock end, a reset end, a gate output end, a low level end, a storage capacitor, a reset module, a first pull-down module, a second pull-down module, a charging module, and an output control module. The present disclosure further discloses a shift register, a driving method, and a display apparatus. The shift register unit circuit according to the present disclosure avoids a power loss, thereby reducing the power consumption of the whole circuit.

## Description

### TECHNICAL FIELD

The present disclosure relates to the field of display technology, and in particular, to a shift register unit circuit, shift register, driving method and display apparatus.

### BACKGROUND

With development of Liquid Crystal Display (LCD) technology, minimization and integration of peripheral circuits gradually become a mainstream technology in the market. The Gate IC on Array (GOA) technology which is used to manufacture a shift register circuit of a Gate IC on an array panel) has been more mature, and structures adopted by various manufacturers are different. An advantage of using the GOA technology is to save the cost, simplify the back-end process flow of the product, and be convenient to achieve a design of flattening a panel and then fixing the flat panel on a mechanical structure of a complete machine end. The most difficult point of the GOA technology is problems in usage life, size, power consumption or the like.

### SUMMARY

In view of this, the present disclosure provides a shift register unit circuit having low power consumption.

According to an aspect of the present disclosure, a shift register unit circuit is provided, comprising: a trigger signal end, a first clock end, a second clock end, a reset end, a gate output end, a low level end, a storage capacitor, a reset module, a first pull-down module, a second pull-down module, a charging module, and an output control module, wherein,

the charging module has a first input end and a first control end connected to the trigger signal end, and a first output end connected to a first end of the storage capacitor to charge the storage capacitor when the trigger signal end is at a high level; and a second input end connected to the first end of the storage capacitor, a second control end connected to the first clock end, and a second output end connected to the trigger signal end to pull a voltage at the first end of the storage capacitor to a low level when the first clock end is at a high level and the trigger signal end is at a low level;

the output control module has an input end connected to the second clock end, a control end connected to the first end of the storage capacitor, and an output end connected to the gate output end, to output a high level signal at the second clock end to the gate output end when the first end of the storage capacitor is at a high level, so that the gate output end is at a high level; and the storage capacitor has a second end connected to the gate output end;

the first pull-down module has a first control end connected to the first clock end, a first input end connected to the gate output end, a first output end connected to the low level end, a second control end connected to the first end of the storage capacitor, a second input end connected to the first clock end, and a second output end connected to the low level end; and the second pull-down module has an input end connected to the gate output end, a control end connected to an intermediate control node of the first pull-down module, and an output end connected to the first end of the storage capacitor, wherein the first pull-down module is configured to pull a voltage at the gate output end to a low level, and trigger the second pull-down module through the intermediate control node to pull voltages at both ends of the storage capacitor to a low level when the first end of the storage capacitor is at a low level; and

the reset module has an input end connected to the first end of the storage capacitor, a control end connected to the reset end, and an output end connected to the gate output end, to pull the voltages at both ends of the storage capacitor to a low level under the control of the reset end.

Preferably, the charging module comprises a fourth transistor and a fifth transistor, wherein the fourth transistor has a gate and a source connected to the trigger signal end, and a drain connected to the first end of the storage capacitor, to transmit a high level signal at the trigger signal end to the first end of the storage capacitor; and the fifth transistor has a gate connected to the first clock end, a source connected to the first end of the storage capacitor, and a drain connected to the trigger signal end, to pull the voltage at the first end of the storage capacitor to a low level when the first clock end is at a high level and the trigger signal end is at a low level.

Preferably, the output control module comprises a first transistor, wherein the first transistor has a gate connected to the first end of the storage capacitor, a source connected to the second clock end, and a drain connected to the gate output end, to output the high level signal at the second clock end to the gate output end when the first end of the storage capacitor is at a high level.

Preferably, the first pull-down module comprises an eighth transistor, a ninth transistor, and a tenth transistor; and the second pull-down module comprises a third transistor and a seventh transistor; wherein,

the ninth transistor has a gate and a source connected to the first clock end, and a drain connected to a source of the eighth transistor, the eighth transistor has a gate connected to the first end of the storage capacitor, and a drain connected to the low level end, the tenth transistor has a gate connected to the first clock end, a source connected to the gate output end, and a drain connected to the low level end, the third transistor has a gate connected to the source of the eighth transistor, a source connected to the gate output end, and a drain connected to the low level end, and the seventh transistor has a gate connected to the source of the eighth transistor, a source connected to the low level end, and a drain connected to the first end of the storage capacitor;

the eighth transistor and the ninth transistor are configured to form a path from the first clock end to the low level end when the first end of the storage capacitor is at a high level, or to change a voltage of the source of the eighth transistor to a high level when the first end of the storage capacitor is at a low level, so that the third transistor and the seventh transistor are turned on, to pull the voltages at both ends of the storage capacitor to a low level; and

the tenth transistor is configured to pull the voltage at the gate output end to a low level when the first clock end is at a high level.

Preferably, the reset module comprises a second transistor and a sixth transistor, wherein the second transistor has a gate connected to the reset end, a source connected to the low level end, and a drain connected to the gate output end, to pull the voltage at the gate output end to a low level when the reset end is at a high level; and the sixth transistor has a gate connected to the reset end, a source connected to the first end of the storage capacitor, and a drain connected to the low level end, to pull the voltage at the first end of the storage capacitor to a low level when the reset end is at a high level.

According to another aspect of the present disclosure, a method for driving the shift register unit circuit as described above is further provided, comprising:

applying a high level to the trigger signal end and the first clock end, and applying a low level to the second clock end and the reset end, so that the storage capacitor is charged by the charging module, and a voltage at the gate output end is pulled by the first pull-down module to a low level;

applying a low level to the trigger signal end, the first clock end, and the reset end, and applying a high level to the second clock end, so that the first end of the storage capacitor is maintained at a high level, and the gate output end is controlled by the output control module to output a high level of the second clock end;

applying a high level to the first clock end and the reset end, and applying a low level to the second clock end and the trigger signal end, so that the voltages at both ends of the storage capacitor and the gate output end are pulled by the reset module to a low level;

applying a low level to the trigger signal end, the first clock end, and the reset end, and applying a high level to the second clock end, so that the voltages at both ends of the storage capacitor and the gate output end are pulled by the second pull-down module to a low level; and

applying a low level to the trigger signal end, the second clock end, and the reset end, and applying a high level to the first clock end, so that the voltage at the gate output end is pulled by the first pull-down module to a low level, and voltages at both ends of the storage capacitor are pulled by the second pull-down module to a low level.

Preferably, the step of applying a high level to the trigger signal end and the first clock end, and applying a low level to the second clock end and the reset end, so that the storage capacitor is charged by the charging module, and the voltage at the gate output end is pulled by the first pull-down module to a low level further comprises:

applying a high level to the trigger signal end and the first clock end, and applying a low level to the second clock end and the reset end, so that the fourth transistor is turned on to charge the first end of the storage capacitor to a high level, and the first transistor and the tenth transistor are turned on, to pull the voltage at the gate output end to a low level.

Preferably, the step of applying a low level to the trigger signal end, the first clock end, and the reset end, and applying a high level to the second clock end, so that the first end of the storage capacitor is maintained at a high level, and the gate output end is controlled by the output control module to output a high level of the second clock end further comprises:

applying a low level to the trigger signal end, the first clock end, and the reset end, and applying a high level to the second clock end, so that the first end of the storage capacitor is maintained at a high level, the first transistor is turned on, and the high level of the second clock end is output by the gate output end.

Preferably, the step of applying a high level to the first clock end and the reset end, and applying a low level to the second clock end and the trigger signal end, so that the voltages at both ends of the storage capacitor and the gate output end are pulled by the reset module to a low level further comprises:

applying a high level to the first clock end and the reset end, and applying a low level to the second clock end and the trigger signal end, so that the second transistor and the sixth transistor are turned on, to pull the voltages at both ends of the storage capacitor and the gate output end to a low level.

Preferably, the step of applying a low level to the trigger signal end, the first clock end, and the reset end, and applying a high level to the second clock end, so that the voltages at both ends of the storage capacitor and the gate output end are pulled by the second pull-down module to a low level further comprises:

applying a low level to the trigger signal end, the first clock end, and the reset end, and applying a high level to the second clock end, so that the third transistor and the seventh transistor are turned on, to pull the voltages at both ends of the storage capacitor and the gate output end to a low level.

Preferably, the step of applying a low level to the trigger signal end, the second clock end, and the reset end, and applying a high level to the first clock end, so that the voltage at the gate output end is pulled by the first pull-down module to a low level, and the voltages at both ends of the storage capacitor are pulled by the second pull-down module to a low level further comprises:

applying a low level to the trigger signal end, the second clock end, and the reset end, and applying a high level to the first clock end, so that the tenth transistor is turned on to pull the voltage at the gate output end to a low level, and the third transistor and the seventh transistor are turned on to pull the voltages at both ends of the storage capacitor to a low level.

According to a further aspect of the present disclosure, a shift register is further provided, comprising a number of cascaded shift register unit circuits as described above.

According to a further aspect of the present disclosure, a display apparatus is further provided, comprising the shift register as described above.

The shift register unit circuit according to the present disclosure has a structure comprising merely 10 Thin Film Transistors (TFT), and will not be turned on and turned off repeatedly with input pulse signals, so as to avoid a power loss, thereby reducing the power consumption of the whole circuit.

### BRIEF DESCRIPTION OF THE DRAWINGS

Fig. 1 is a structural diagram of a shift register unit circuit according to an embodiment of the present disclosure;
Fig. 2 is a sequence diagram of an operation of a shift register unit circuit according to an embodiment of the present disclosure; and
Fig. 3 is a structural diagram of a shift register according to an embodiment of the present disclosure.

### DETAILED DESCRIPTION

The specific implementations of the present disclosure will be further described in detail below in conjunction with drawings and embodiments. The following embodiments are used to illustrate the present disclosure, instead of limiting the scope of the present disclosure.

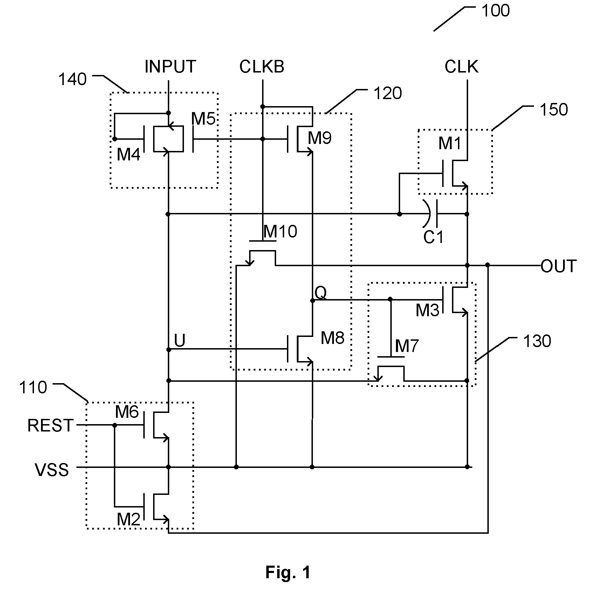

A shift register unit circuit 100 according to an embodiment of the present disclosure is shown in Fig. 1, and comprises a trigger signal end INPUT, a first clock end CLKB, a second clock end CLK, a reset end REST, a gate output end OUT, and a low level end VSS. The shift register unit circuit 100 as shown in Fig. 1 further comprises a storage capacitor C1, a reset module 110, a first pull-down module 120, a second pull-down module 130, a charging module 140 and an output control module 150.

In the GOA, voltages of gate lines are comprised of a row of high level voltages over time and multiple rows of low level voltages over time. The high level voltage Vgh is obtained by outputting a high level voltage of a clock signal from the GOA circuit, and the low level voltage Vgl is generally obtained by outputting a VSS voltage from the GOA circuit. Therefore, in the embodiment of the present disclosure, the low level end VSS provides a reference voltage as a low level, which is the same as low levels of the clock signals (a first clock signal provided by the first clock end CLKB and a second clock signal provided by the second clock end CLK), i.e., a voltage Vgl of a signal on the gate line. A high level of the clock signal is provided as the voltage Vgh of the gate line.

The charging module 140 has a first input end and a first control end connected to the trigger signal end INPUT, and a first output end connected to a first end of the storage capacitor C1 to charge the storage capacitor C1 when the trigger signal end INPUT is at a high level; and a second input end connected to the first end of the storage capacitor, a second control end connected to the first clock end CLKB, and a second output end connected to the trigger signal end INPUT to pull a voltage at the first end of the storage capacitor to a low level when the first clock end CLKB is at a high level and the trigger signal end INPUT is at a low level.

The output control module 150 has an input end connected to the second clock end CLK, a control end connected to the first end of the storage capacitor, and an output end connected to the gate output end OUT, to output a high level signal at the second clock end CLK to the gate output end OUT when the first end of the storage capacitor C1 is at a high level, so that the gate output end OUT is at a high level; and the storage capacitor C1 has a second end connected to the gate output end OUT.

The first pull-down module 120 has a first control end connected to the first clock end CLKB, a first input end connected to the gate output end OUT, a first output end connected to the low level end VSS, a second control end connected to the first end of the storage capacitor, a second input end connected to the first clock end CLKB, and a second output end connected to the low level end VSS.

The second pull-down module 130 has an input end connected to the gate output end OUT, a control end connected to an intermediate control node Q of the first pull-down module 120, and an output end connected to the first end of the storage capacitor.

The first pull-down module 120 is configured to pull a voltage at the gate output end OUT to a low level, and trigger the second pull-down module through the intermediate control node Q to pull voltages at both ends of the storage capacitor C1 to a low level when the first end of the storage capacitor C1 is at a low level.

The reset module 110 has an input end connected to the first end of the storage capacitor, a control end connected to the reset end REST, and an output end connected to the gate output end OUT. As the storage capacitor C1 has a second end connected to the gate output end OUT, the reset module 110 is configured to pull the voltages at both ends of the storage capacitor C1 to a low level under the control of the reset end REST.

Fig. 1 further illustrates a specific example of various modules.

In the present embodiment, the charging module 140 comprises a fourth transistor M4 and a fifth transistor M5, wherein the fourth transistor M4 has a gate and a source connected to the trigger signal end INPUT, and a drain connected to the first end U of the storage capacitor C1, to transmit a high level signal at the trigger signal end INPUT to the first end of the storage capacitor C1; and the fifth transistor M5 has a gate connected to the first clock end CLKB, a source connected to the first end of the storage capacitor C1, and a drain connected to the trigger signal end INPUT, to pull the voltage at the first end of the storage capacitor C1 to a low level when the first clock end CLKB is at a high level and the trigger signal end INPUT is at a low level. In the present embodiment, the source, the gate and the drain of the fourth transistor M4 correspond to the first input end, the first control end, and the first output end of the charging module 140 respectively, and the source, the gate and the drain of the fifth transistor M5 correspond to the second input end, the second control end, and the second output end of the charging module 140 respectively.

In the present embodiment, the output control module 150 comprises a first transistor M1, wherein the first transistor M1 has a gate connected to the first end of the storage capacitor C1, a source connected to the second clock end CLK, and a drain connected to the gate output end OUT, to output a high level signal at the second clock end CLK to the gate output end OUT when the first end of the storage capacitor C1 is at a high level. In the present embodiment, the source, the gate and the drain of the first transistor M1 correspond to the input end, the control end, and the output end of the output control module 150 respectively.

In the present embodiment, the first pull-down module 120 comprises an eighth transistor M8, a ninth transistor M9, and a tenth transistor M10.

In the present embodiment, the second pull-down module 130 comprises a third transistor M3 and a seventh transistor M7.

The ninth transistor M9 has a gate and a source connected to the first clock end CLKB, and a drain connected to a source of the eighth transistor M8, the eighth transistor M8 has a gate connected to the first end U of the storage capacitor C1, and a drain connected to the low level end VSS, the tenth transistor M10 has a gate connected to the first clock end CLKB, a source connected to the gate output end OUT, and a drain connected to the low level end VSS, the third transistor M3 has a gate connected to the source of the eighth transistor M8, a source connected to the gate output end OUT, and a drain connected to the low level end VSS, and the seventh transistor M7 has a gate connected to the source of the eighth transistor M8, a source connected to the low level end VSS, and a drain connected to the first end of the storage capacitor C1.

The eighth transistor M8 and the ninth transistor M9 are configured to form a path from the first clock end CLKB to the low level end VSS when the first end of the storage capacitor C1 is at a high level, or to change a voltage of the source (i.e., the intermediate control node Q) of the eighth transistor M8 to a high level when the first end of the storage capacitor C1 is at a low level, so that the third transistor M3 and the seventh transistor M7 are turned on, to pull the voltages at both ends of the storage capacitor C1 to a low level; and the tenth transistor M10 is configured to pull the voltage at the gate output end OUT to a low level when the first clock end CLKB is at a high level.

In the present embodiment, the source, the gate and the drain of the tenth transistor M10 correspond to the first input end, the first control end, and the first output end of the first pull-down module 120 respectively, and the source of the ninth transistor, the gate of the eighth transistor and the drain of the eighth transistor correspond to the second input end, the second control end, and the second output end of the first pull-down module 120 respectively. In the present embodiment, the source of the third transistor M3, the gate of the third transistor M3 and the drain of the seventh transistor M7 correspond to the input end, the control end, and the output end of the second pull-down module 130 respectively.

In the present embodiment, the reset module 110 comprises a second transistor M2 and a sixth transistor M6, wherein the second transistor M2 has a gate connected to the reset end REST, a source connected to the low level end VSS, and a drain connected to the gate output end OUT, to pull the voltage at the gate output end OUT to a low level when the reset end REST is at a high level; and the sixth transistor M6 has a gate connected to the reset end REST, a source connected to the first end of the storage capacitor C1, and a drain connected to the low level end VSS, to pull the voltage at the first end of the storage capacitor C1 to a low level when the reset end REST is at a high level. In the present embodiment, the source of the sixth transistor, the gate of the sixth transistor and the drain of the second transistor correspond to the input end, the control end, and the output end of the reset module 110 respectively.

In the embodiment illustrated in Fig. 1, various transistors are illustrated by taking N-type transistors as an example. However, those skilled in the art should understand that various modules according to the present disclosure are not limited to the specific structure illustrated in Fig. 1, and other types of transistors may also be used.

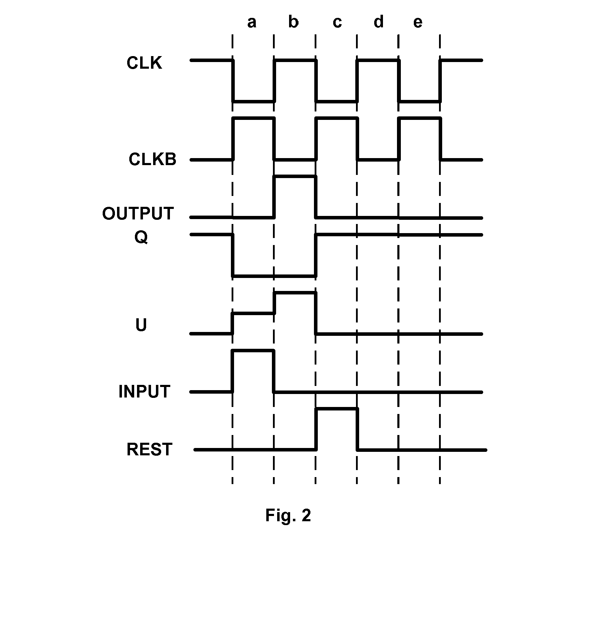

A sequence diagram of an operation of the gate driving circuit according to the present embodiment is shown in Fig. 2, and the specific operating principle is as follows.

In stage a, a signal at the INPUT end is at a high level, the REST end and the CLK end are at a low level, the CLKB end is at a high level, M4 is turned on, the first end (point U) of C1 is charged to a high level, M1, M5, M8, M10 and M9 are turned on, potentials at the point Q and the OUT end are pulled to a low level, an output of the OUT end is at a low level, and M2, M3, M6 and M7 are in a turn-off state. This stage is a charging stage.

In stage b, the CLK end is at a high level, the INPUT end, the REST end, and the CLKB end are at a low level; as the first end (the point U) of C1 is maintained at a high level as in stage a, M1 and M8 are still turned on, the point Q is still at a low level, a voltage at the point U is raised up due to the coupling of the CLK end, and the output of the OUT end is at a high level of the CLK end; and M2, M3, M4, M5, M6, M7, M9 and M10 are in a turn-off state. This stage is an output stage.

In stage c, the INPUT end and the CLK end are at a low level, the CLKB end and the REST end are at a high level, and at this time, M6, M2, M5, M9 and M10 are turned on; as M2 and M10 are turned on, the voltage at the OUT is pulled to a low level, i.e., the output of the OUT end is at a low level; as the INPUT end is at a low level, a voltage at the point U is pulled down, which results in the point Q being charged to a high level, M7 and M3 are turned on, and the point U and the OUT end are connected to the VSS end; and as a voltage at the VSS end is the same as the voltage Vgl of the gate line of the GOA, the connection between the OUT end and the VSS end achieves a function of stabilizing the voltage Vgl of the gate line, and M1, M4, M7 and M8 are in a turn-off state. This stage is a reset stage.

In stage d, signals at the INPUT end, the CLKB end, and the REST end are at a low level, and the CLK end is at a high level. In this stage, as there is no discharge path, the voltage at the point Q is still maintained in a high level state. Except that M3 and M7 are turned on, M1, M2, M4, M5, M6, M8, M9 and M10 are in a turn-off state. Turn-on of M7 and M3 enables the point U and the OUT end to be connected to the VSS end continuously, to stabilize the voltage Vgl of the gate line. At this time, the output of the OUT is at a low level. This stage is a first stable stage.

In stage e, signals at the INPUT end, the CLK end, and the REST end are at a low level, the CLKB end is at a high level, M5, M9 and M10 are turned on, the voltage at the point Q is still maintained at a high level, M3 and M7 which are controlled by the point Q are still maintained in a turn-on state; M10 and M3 enable the OUT end to be connected to VSS, and M5 and M7 enable the point U to be connected to VSS, to keep a stable voltage of the gate line; and M1, M2, M4, M6 and M8 are in a turn-off state. This stage is a second stable stage.

As for the unit circuit, in a subsequent time sequence, the signals at the INPUT end and the REST end are always at a low level, and the CLK end and the CLKB end are alternatively at a high level and at a low level, i.e., the stage d and the stage e are repeated, which will not be described in detail here.

The shift register unit circuit according to the present disclosure has a structure comprising merely 10 Thin Film Transistors (TFT), and will not be turned on and turned off repeatedly with input pulse signals, so as to avoid a power loss, thereby reducing the power consumption of the whole circuit. A diode structure of the ninth transistor, i.e., M9 in Fig. 1 (the gate and the source of M9 are connected) forms a waveform (a waveform at point Q in Fig. 2) similar to direct current instead of a waveform in a wavy shape according to the characteristic of the diode, which further reduces the power consumption of the circuit. Further, the shift register unit circuit according to the present disclosure merely comprises 10 transistors, so as to achieve a smaller size of the product.

The present disclosure further provides a method for driving the shift register unit circuit as described above, which comprises the following stages.

In a first stage, a high level is applied to the trigger signal end and the first clock end, and a low level is applied to the second clock end and the reset end, so that the storage capacitor is charged by the charging module, and the voltage at the gate output end is pulled by the first pull-down module to a low level. Specifically, in combination with the embodiment illustrated in Fig. 1, when a high level is applied to the trigger signal end and the first clock end, and a low level is applied to the second clock end and the reset end, the fourth transistor is turned on to charge the first end (the point U) of the storage capacitor to a high level, and the first transistor and the tenth transistor are turned on, to pull the voltage at the gate output end to a low level.

In a second stage, a low level is applied to the trigger signal end, the first clock end, and the reset end, and a high level is applied to the second clock end, so that the first end of the storage capacitor is maintained at a high level, and the gate output end is controlled by the output control module to output a high level of the second clock end. Specifically, in combination with the embodiment illustrated in Fig. 1, when a low level is applied to the trigger signal end, the first clock end, and the reset end, and a high level is applied to the second clock end, the first end of the storage capacitor is maintained at a high level, and the first transistor is turned on, so that the high level of the second clock end is output by the gate output end.

In a third stage, a high level is applied to the first clock end and the reset end, and a low level is applied to the second clock end and the trigger signal end, so that the voltages at both ends of the storage capacitor and the gate output end are pulled by the reset module to a low level. Specifically, in combination with the embodiment illustrated in Fig. 1, when a high level is applied to the first clock end and the reset end, and a low level is applied to the second clock end and the trigger signal end, the second transistor and the sixth transistor are turned on, to pull the voltages at both ends of the storage capacitor and the gate output end to a low level.

In a fourth stage, a low level is applied to the trigger signal end, the first clock end, and the reset end, and a high level is applied to the second clock end, so that the voltages at both ends of the storage capacitor and the gate output end are pulled by the second pull-down module to a low level. Specifically, in combination with the embodiment illustrated in Fig. 1, when a low level is applied to the trigger signal end, the first clock end, and the reset end, and a high level is applied to the second clock end, the third transistor and the seventh transistor are turned on, to pull the voltages at both ends of the storage capacitor and the gate output end to a low level.

In a fifth stage, a low level is applied to the trigger signal end, the second clock end, and the reset end, and a high level is applied to the first clock end, so that the voltage at the gate output end is pulled by the first pull-down module to a low level, and the voltages at both ends of the storage capacitor are pulled by the second pull-down module to a low level. Specifically, in combination with the embodiment illustrated in Fig. 1, when a low level is applied to the trigger signal end, the second clock end, and the reset end, and a high level is applied to the first clock end, the tenth transistor is turned on to pull the voltage at the gate output end to a low level, and the third transistor and the seventh transistor are turned on, to pull the voltages at both ends of the storage capacitor to a low level.

The present disclosure further provides a shift register, comprising a number of cascaded shift register unit circuits as described above.

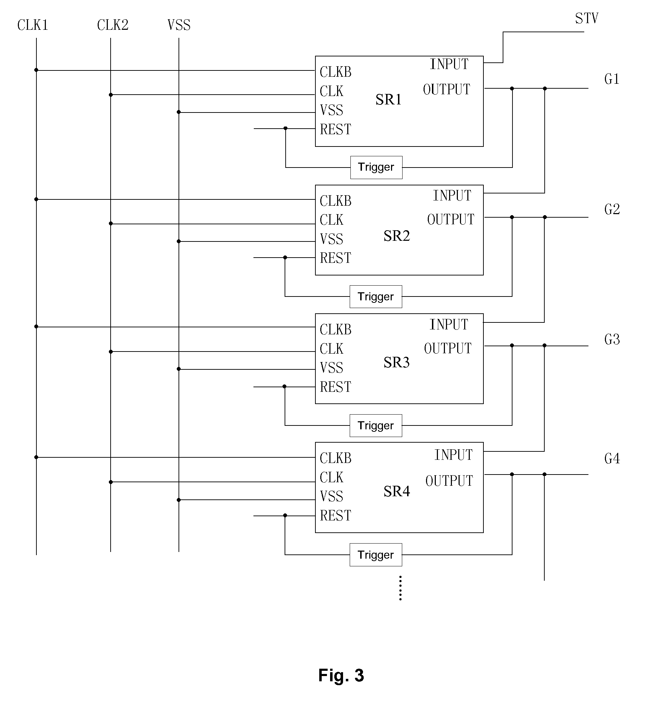

Fig. 3 illustrates a structural diagram of a shift register according to an embodiment of the present disclosure. The shift register according to the embodiment of the present disclosure comprises multiple cascaded shift register unit circuits, wherein a first shift register unit circuit has a trigger signal end connected to an input signal end to receive a trigger signal STV, in any two adjacent shift register unit circuits except for the first shift register unit circuit and the last shift register unit circuit, a previous shift register unit circuit has a gate output end connected to a trigger signal end of a next shift register unit circuit, and each shift register unit circuit has a first clock end for receiving a first clock signal, a second clock end for receiving a second clock signal, a low voltage end for receiving a low voltage signal, and a reset end for receiving a reset signal.

Each shift register unit circuit has a gate output end connected to a gate line, to provide a switch signal to a switch in a pixel unit connected to the gate line.

Specifically, the shift register illustrated in Fig. 3 comprises multiple cascaded shift register unit circuits SR1, SR2, SR3, SR4..., wherein the first shift register unit circuit SR1 has a gate output end OUTPUT connected to a trigger signal end INPUT of the second shift register unit circuit SR2 and a gate line G1; the second shift register unit circuit SR2 has a gate output end OUTPUT connected to a trigger signal end INPUT of the third shift register unit circuit SR3 and a gate line G2; the third shift register unit circuit SR3 has a gate output end OUTPUT connected to a trigger signal end INPUT of the fourth shift register unit circuit SR4 and a gate line G3; and other shift register unit circuits are connected in the same manner. Further, each shift register unit circuit has two clock ends and a low voltage end, wherein for each shift register unit circuit, the first clock end is connected to a first clock signal input end CLK1, the second clock end is connected to a second clock signal input end CLK2, and the low voltage end is connected to the low voltage input end VSS. Each shift register unit circuit has a reset end for receiving a reset signal. For example, as shown in Fig. 3, the reset signal may be obtained by a mono-stable trigger which is triggered by a falling edge delaying an output signal at the gate output end of the shift register unit circuit by one period. Of course, other methods for providing a reset signal are feasible. The present disclosure is not limited thereto.

The present disclosure further provides a display apparatus comprising the shift register described above. The display apparatus may be any product or component having a display function such as a liquid crystal panel, an OLED panel, a mobile phone, a tablet computer, a television, a display, a notebook computer, a digital photo frame, a navigator or the like.

The above embodiments are merely used to illustrate the present disclosure, instead of limiting the present disclosure. Various changes and variations can be made by those skilled in the art without departing from the spirit and scope of the present disclosure. Therefore, all equivalent technical solutions also belong to the scope of the present disclosure. The protection scope of the present disclosure should be defined by the claims.

## Claims

1. A shift register unit circuit, comprising: a trigger signal end, a first clock end, a second clock end, a reset end, a gate output end, a low level end, a storage capacitor, a reset module, a first pull-down module, a second pull-down module, a charging module, and an output control module, wherein,
the charging module has a first input end and a first control end connected to the trigger signal end, and a first output end connected to a first end of the storage capacitor to charge the storage capacitor when the trigger signal end is at a high level; and a second input end connected to the first end of the storage capacitor, a second control end connected to the first clock end, and a second output end connected to the trigger signal end to pull a voltage at the first end of the storage capacitor to a low level when the first clock end is at a high level and the trigger signal end is at a low level;
the output control module has an input end connected to the second clock end, a control end connected to the first end of the storage capacitor, and an output end connected to the gate output end, to output a high level signal at the second clock end to the gate output end when the first end of the storage capacitor is at a high level, so that the gate output end is at a high level; and the storage capacitor has a second end connected to the gate output end;
the first pull-down module has a first control end connected to the first clock end, a first input end connected to the gate output end, a first output end connected to the low level end, a second control end connected to the first end of the storage capacitor, a second input end connected to the first clock end, and a second output end connected to the low level end; and the second pull-down module has an input end connected to the gate output end, a control end connected to an intermediate control node of the first pull-down module, and an output end connected to the first end of the storage capacitor, wherein the first pull-down module is configured to pull a voltage at the gate output end to a low level, and trigger the second pull-down module through the intermediate control node to pull voltages at both ends of the storage capacitor to a low level when the first end of the storage capacitor is at a low level; and
the reset module has an input end connected to the first end of the storage capacitor, a control end connected to the reset end, and an output end connected to the gate output end, to pull the voltages at both ends of the storage capacitor to a low level under the control of the reset end.

2. The shift register unit circuit according to claim 1, wherein the charging module comprises a fourth transistor and a fifth transistor, wherein the fourth transistor has a gate and a source connected to the trigger signal end, and a drain connected to the first end of the storage capacitor, to transmit a high level signal at the trigger signal end to the first end of the storage capacitor; and the fifth transistor has a gate connected to the first clock end, a source connected to the first end of the storage capacitor, and a drain connected to the trigger signal end, to pull the voltage at the first end of the storage capacitor to a low level when the first clock end is at a high level and the trigger signal end is at a low level.

3. The shift register unit circuit according to claim 2, wherein the output control module comprises a first transistor, wherein the first transistor has a gate connected to the first end of the storage capacitor, a source connected to the second clock end, and a drain connected to the gate output end, to output the high level signal at the second clock end to the gate output end when the first end of the storage capacitor is at a high level.

4. The shift register unit circuit according to claim 3, wherein the first pull-down module comprises an eighth transistor, a ninth transistor, and a tenth transistor; and the second pull-down module comprises a third transistor and a seventh transistor; wherein,
the ninth transistor has a gate and a source connected to the first clock end, and a drain connected to a source of the eighth transistor, the eighth transistor has a gate connected to the first end of the storage capacitor, and a drain connected to the low level end, the tenth transistor has a gate connected to the first clock end, a source connected to the gate output end, and a drain connected to the low level end, the third transistor has a gate connected to the source of the eighth transistor, a source connected to the gate output end, and a drain connected to the low level end, and the seventh transistor has a gate connected to the source of the eighth transistor, a source connected to the low level end, and a drain connected to the first end of the storage capacitor;
the eighth transistor and the ninth transistor are configured to form a path from the first clock end to the low level end when the first end of the storage capacitor is at a high level, or to change a voltage of the source of the eighth transistor to a high level when the first end of the storage capacitor is at a low level, so that the third transistor and the seventh transistor are turned on, to pull the voltages at both ends of the storage capacitor to a low level; and
the tenth transistor is configured to pull the voltage at the gate output end to a low level when the first clock end is at a high level.

5. The shift register unit circuit according to claim 4, wherein the reset module comprises a second transistor and a sixth transistor, wherein the second transistor has a gate connected to the reset end, a source connected to the low level end, and a drain connected to the gate output end, to pull the voltage at the gate output end to a low level when the reset end is at a high level; and the sixth transistor has a gate connected to the reset end, a source connected to the first end of the storage capacitor, and a drain connected to the low level end, to pull the voltage at the first end of the storage capacitor to a low level when the reset end is at a high level.

6. A method for driving the shift register unit circuit according to claim 5, comprising:
applying a high level to the trigger signal end and the first clock end, and applying a low level to the second clock end and the reset end, so that the storage capacitor is charged by the charging module, and a voltage at the gate output end is pulled by the first pull-down module to a low level;
applying a low level to the trigger signal end, the first clock end, and the reset end, and applying a high level to the second clock end, so that the first end of the storage capacitor is maintained at a high level, and the gate output end is controlled by the output control module to output a high level of the second clock end;
applying a high level to the first clock end and the reset end, and applying a low level to the second clock end and the trigger signal end, so that the voltages at both ends of the storage capacitor and the gate output end are pulled by the reset module to a low level;
applying a low level to the trigger signal end, the first clock end, and the reset end, and applying a high level to the second clock end, so that the voltages at both ends of the storage capacitor and the gate output end are pulled by the second pull-down module to a low level; and
applying a low level to the trigger signal end, the second clock end, and the reset end, and applying a high level to the first clock end, so that the voltage at the gate output end is pulled by the first pull-down module to a low level, and voltages at both ends of the storage capacitor are pulled by the second pull-down module to a low level.

7. The method according to claim 6, wherein the step of applying a high level to the trigger signal end and the first clock end, and applying a low level to the second clock end and the reset end, so that the storage capacitor is charged by the charging module, and the voltage at the gate output end is pulled by the first pull-down module to a low level further comprises:
applying a high level to the trigger signal end and the first clock end, and applying a low level to the second clock end and the reset end, so that the fourth transistor is turned on to charge the first end of the storage capacitor to a high level, and the first transistor and the tenth transistor are turned on, to pull the voltage at the gate output end to a low level.

8. The method according to claim 6, wherein the step of applying a low level to the trigger signal end, the first clock end, and the reset end, and applying a high level to the second clock end, so that the first end of the storage capacitor is maintained at a high level, and the gate output end is controlled by the output control module to output a high level of the second clock end further comprises:
applying a low level to the trigger signal end, the first clock end, and the reset end, and applying a high level to the second clock end, so that the first end of the storage capacitor is maintained at a high level, the first transistor is turned on, and the high level of the second clock end is output by the gate output end.

9. The method according to claim 6, wherein the step of applying a high level to the first clock end and the reset end, and applying a low level to the second clock end and the trigger signal end, so that the voltages at both ends of the storage capacitor and the gate output end are pulled by the reset module to a low level further comprises:
applying a high level to the first clock end and the reset end, and applying a low level to the second clock end and the trigger signal end, so that the second transistor and the sixth transistor are turned on, to pull the voltages at both ends of the storage capacitor and the gate output end to a low level.

10. The method according to claim 6, wherein the step of applying a low level to the trigger signal end, the first clock end, and the reset end, and applying a high level to the second clock end, so that the voltages at both ends of the storage capacitor and the gate output end are pulled by the second pull-down module to a low level further comprises:
applying a low level to the trigger signal end, the first clock end, and the reset end, and applying a high level to the second clock end, so that the third transistor and the seventh transistor are turned on, to pull the voltages at both ends of the storage capacitor and the gate output end to a low level.

11. The method according to claim 6, wherein the step of applying a low level to the trigger signal end, the second clock end, and the reset end, and applying a high level to the first clock end, so that the voltage at the gate output end is pulled by the first pull-down module to a low level, and the voltages at both ends of the storage capacitor are pulled by the second pull-down module to a low level further comprises:
applying a low level to the trigger signal end, the second clock end, and the reset end, and applying a high level to the first clock end, so that the tenth transistor is turned on to pull the voltage at the gate output end to a low level, and the third transistor and the seventh transistor are turned on to pull the voltages at both ends of the storage capacitor to a low level.

12. A shift register, comprising a number of cascaded shift register unit circuits according to any of claims 1-5, wherein a first shift register unit circuit has a trigger signal end connected to an input signal end, in any two adjacent shift register unit circuits except for the first shift register unit circuit and the last shift register unit circuit, a previous shift register unit circuit has a gate output end connected to a trigger signal end of a next shift register unit circuit, and each shift register unit circuit has a first clock end for receiving a first clock signal, a second clock end for receiving a second clock signal, a low voltage end for receiving a low voltage signal, and a reset end for receiving a reset signal.

13. A display apparatus comprising the shift register according to claim 12.
